(19) Europäisches Patentamt
European Patent Office
Office européen des brevets

(11) **EP 2 491 657 B1**

(12) **FASCICULE DE BREVET EUROPEEN**

(45) Date de publication et mention de la délivrance du brevet:
**20.12.2017 Bulletin 2017/51**

(51) Int Cl.:
*H03M 5/12* (2006.01)       *G06K 7/00* (2006.01)
*G06K 19/07* (2006.01)

(21) Numéro de dépôt: **10773019.4**

(22) Date de dépôt: **19.10.2010**

(86) Numéro de dépôt international:
**PCT/EP2010/065736**

(87) Numéro de publication internationale:
**WO 2011/048107 (28.04.2011 Gazette 2011/17)**

(54) **PROCÉDÉ DE CODAGE DE DONNÉES D'UNE COMMUNICATION SANS CONTACT D'UN TRANSPONDEUR VERS UN LECTEUR PAR MODULATION DE CHARGE, SOUS FORME D'UN ENSEMBLE DE MOTIFS ET DISPOSITIF POUR SA MISE EN OEUVRE**

VERFAHREN ZUR KODIERUNG VON KONTAKTLOSEN KOMMUNIKATIONSDATEN AUS EINEM TRANSPONDER AN EIN LESEGERÄT MITTELS LADUNGSMODULATION IN FORM EINES SATZES VON MUSTERN UND VORRICHTUNG ZUR UMSETZUNG DES VERFAHRENS

METHOD FOR ENCODING CONTACTLESS COMMUNICATION DATA FROM A TRANSPONDER TO A READER VIA CHARGE MODULATION, IN THE FORM OF A SET OF PATTERNS AND DEVICE FOR IMPLEMENTING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.10.2009  FR 0905003**

(43) Date de publication de la demande:
**29.08.2012  Bulletin 2012/35**

(73) Titulaire: **Commissariat à l'Énergie Atomique et aux Énergies Alternatives
75015 Paris (FR)**

(72) Inventeurs:
- **PEBAY-PEYROULA, Florian**
  **38250 Saint Nizier du Moucherot (FR)**
- **CROCHON, Elisabeth**
  **38320 Poisat (FR)**
- **REVERDY, Jacques**
  **38920 Crolles (FR)**
- **THOMAS, Thierry**
  **38760 Varces Allieres et Risset (FR)**

(74) Mandataire: **Croonenbroek, Thomas Jakob et al
Innovincia
11, avenue des Tilleuls
74200 Thonon-les-Bains (FR)**

(56) Documents cités:
WO-A1-03/088499       WO-A2-2007/149219
US-B1- 6 422 476       US-B1- 7 460 035

- **JAE-MIN SEOL ET AL: "Collision-Resilient Multi-state Query Tree Protocol for Fast RFID Tag Identification", 3 novembre 2006 (2006-11-03), COMPUTATIONAL INTELLIGENCE AND SECURITY; [LECTURE NOTES IN COMPUTER SCIENCE], SPRINGER BERLIN HEIDELBERG, BERLIN, HEIDELBERG, PAGE(S) 733 - 742, XP019098199, ISBN: 978-3-540-74376-7 alinéa [0001]; figure 2**
- **Anonymus: "Radio-Frequency-Identification: types of RFID", , 31 juillet 2008 (2008-07-31), XP002580189, Extrait de l'Internet: URL:http://web.archive.org/web/20080731081 210/http://www.rfid-handbook.de/rfid/types _of_rfid.html [extrait le 2010-04-26]**
- **Sanjay E. Sarma. Stephen A. Weis. Daniel W. Engels: "RFID Systems and Security and Privacy Implications", Lecture Notes In Computer Science, vol. 2523 31 décembre 2002 (2002-12-31), pages 454-469, XP002580190, London, UK ISBN: 3-540-00409-2 Extrait de l'Internet: URL:http://saweis.net/pdfs/ches-rfid.pdf [extrait le 2010-04-26]**

- **PETE SORRELLS: 'Application Note AN680. Passive RFID Basics' INTERNET CITATION, [en ligne] 31 Décembre 1998, pages 1 - 5, XP055001961 Extrait de l'Internet: <URL:http://ww1.microchip.com/downloads/en/AppNotes/00680b.pdf> [extrait le 2011-07-05]**

- **ANONYMOUS: 'Amplitude-shift keying - Wikipedia, the free encyclopedia' INTERNET CITATION, [en ligne] 24 Avril 2009, XP055188539 Extrait de l'Internet: <URL:http://web.archive.org/web/20090424141948/http://en.wikipedia.org/wiki/Amplitude-shift_keying> [extrait le 2015-05-11]**

## Description

La présente invention concerne de façon générale la technique de codage de données dans le cadre d'échanges de données entre un lecteur ou station de base fixe et un transpondeur sans contact (carte, étiquette) placé dans le champ électromagnétique émis par le lecteur.

Plus précisément, l'invention concerne un procédé de codage de données d'une communication sans contact d'un transpondeur vers un lecteur par modulation de charge, sous forme d'un ensemble de motifs et un dispositif pour la mise en oeuvre du procédé.

Les systèmes électroniques radiofréquences pour l'identification (RFID pour « radio frequency identification device » en anglais) trouvent des applications de plus en plus répandues.

En effet, ces systèmes sont déjà aujourd'hui largement utilisés pour identifier, localiser ou suivre des objets, des animaux et des personnes (cartes d'accès ; péage ; passeport électronique etc).

Il s'agit en général d'un lecteur (« reader » en anglais) et d'un transpondeur intégré par exemple dans un support tel qu'une étiquette ou une carte (« tag » ou « card » en anglais). Dans la présente invention, on se réfère aux transpondeurs passifs, c'est-à-dire des transpondeurs ne disposant pas d'une source d'énergie propre pour transmettre des données.

Le lecteur, considéré comme une station de base, génère une onde porteuse (champ magnétique alternatif de courte portée) qui sert à alimenter les cartes sans-contact à proximité de l'antenne du lecteur. On parle alors de téléalimentation. De plus, cette onde porteuse fournit à la carte une horloge pour le fonctionnement de ses différents blocs. Enfin, elle sert de support pour les communications lecteur - carte et carte - lecteur.

On distingue dans l'échange des informations entre la station de base et le transpondeur la voie du lecteur vers la carte et la voie de la carte vers le lecteur.

Pour cette dernière, une rétromodulation (d'amplitude ou de phase) est appliquée par le transpondeur passif sur la porteuse par contrôle d'une charge variable, par exemple résistive ou capacitive, aux bornes de l'antenne de la carte.

Cette commutation provoque une réaction d'induit du coté du lecteur, ce qui peut être démodulé et décodé pour obtenir les informations stockées dans la carte.

Dans ce qui suit, le terme « symbole » signifie un élément d'un alphabet de codage de données. Un symbole peut par exemple être un ensemble de 3 bits, tel que 011.

Dans le présent contexte, on utilise le terme « motif ou motif de modulation» pour une succession de niveaux de charge d'une longueur prédéfinie servant au codage physique, c'est-à-dire la rétromodulation.

Un motif correspond à un symbole et est caractérisé par sa longueur et une succession de niveaux de charge.

### Etat de la technique

Tout d'abord il convient de citer la norme ISO 14 443 qui définit et permet d'établir une communication entre un lecteur et une carte sur la base d'une porteuse ($f_C$) à 13,56MHz avec un débit entre 106 kbits/s et 848 kbits/s. Cette norme propose deux types de rétromodulation (type A et type B), faisant appel à la notion de sous-porteuse à 848 kHz ($f_{SC}= f_C/16)$.

Toutefois, pour certaines applications, comme par exemple l'identification biométrique ou un passeport électronique, ce débit n'est pas suffisant.

Différentes solutions ont été proposées afin d'augmenter le débit pouvant être atteint entre la carte et le lecteur.

Une première approche proposée par le présent Demandeur consistait à augmenter la fréquence de la sous-porteuse à 1,7Mbit/s ($f_{SC} = f_C/8$) et en modulant la phase de la sous - porteuse. Ainsi des débits de 1,7Mbit/s et 3,4 Mbit/s ont pu être atteints.

En se détachant du canevas de la fréquence sousporteuse à 848 kHz et en proposant une fréquence sous-porteuse jusqu'à 27,12 MHz, d'autres approches ont pu atteindre des débits théoriques allant jusqu'à 27,12 Mbits/s.

Plus en détail, une première solution évidente à ce problème consisterait à augmenter le nombre de symboles.

Par symbole, on entend les caractères individuels d'un alphabet de codage. Avec une sousporteuse de 848 kHz à 27.12 MHz et des déphasages $\Delta\varphi$ de $\pi$, $\pi/2$, $\pi/4$, $\pi/8$, $\pi/16$, $\pi/32$, $\pi/64$ et $\pi/128$ permet de couvrir une plage de débit de 106 kbit/s à 27.12 Mbit/s.

Une seconde solution évidente pour augmenter le débit à nombre de symboles constant consistera à diminuer le temps symbole.

Ainsi, les symboles '0' et '1' sont par exemple représentés par un code Manchester classique et le temps symbole est variable. Le débit binaire est alors égal à la fréquence sous-porteuse.

Dans le cas où le temps symbole équivaut à la période de la porteuse à 13,56 MHz, on arrive donc à un débit de 13,56 Mbits/s.

Toutefois, on constate que la bande passante des signaux en bande de base augmente très fortement avec le débit ce qui nuit à la récupération de l'énergie de la carte et fragilise donc son fonctionnement, voir diminue sa portée.

Ces deux solutions qui viennent naturellement à l'esprit d'un homme du métier, ne répondent donc pas au problème posé.

Enfin, une solution proposée pour une application RFID UHF dans le document WO2007/149219 se base, à temps symbole constant, sur une modulation 16 QAM (pour « Quadrature Amplitude Modulation » en anglais, c'est-à-dire une modulation à quadrature d'amplitude), avec deux états d'amplitude et huit états de phase.

Toutefois, cette solution est complexe à transposer à un fonctionnement à 13,56MHz, car côté carte, il est nécessaire de pouvoir sélectionner à la fois le type de rétromodulation ainsi que la valeur de la charge de rétromodulation appliquée à l'antenne.

Le procédé décrit dans ce document permet de coder un message m de n bits en modulant simultanément la phase et l'amplitude d'une fréquence porteuse. A chaque message de n bits à transmettre, une cartographie (mapper - diagramme de constellation) associe un point d'un plan complexe.

Toutefois, ce diagramme de constellation qui associe une phase et une amplitude de la fréquence porteuse, ne peut pas être associé à des motifs de modulation.

Le document WO 03/088499 est relatif à un procédé d'encodage entre un lecteur et un transpondeur passif.

Cette solution propose un schéma d'encodage dans lequel n phases (n étant un nombre entier) d'une sous-porteuse sont utilisées pour encoder n bits dans un temps normalement prévu pour 1 bit dans un schéma d'encodage conventionnel.

En alternative, ce document propose l'utilisation de différentes sous-porteuses à la place ou en combinaison avec les n phases.

En référence à la figure 5 de ce document, 3 bits sont codés par symbole soit avec huit cycles de sous-porteuse pour les symboles 1 à 4, soit avec six cycles de sous-porteuse pour les symboles 5 à 8.

En supposant un fonctionnement avec une fréquence porteuse à 13,56MHz et temps symbole de 8/ $f_{SC}$ (sous-porteuses à 848kHz et 636-kHz), on en déduit que le débit atteint n'est que de 318kbits/s.

Par ailleurs, le document US 6 422 476 décrit un procédé de compression/décompression de données pour minimiser la taille mémoire occupée par une chaine de caractères.

Les chaînes de caractères divulguées dans ce document sont seulement des symboles au sens de la présente demande de brevet, c'est-à-dire des éléments d'un alphabet de codage.

Ce document ne divulgue nullement des motifs de modulation qui doivent tenir compte de la transmission physique des données.

La présente invention vise à proposer un procédé de codage de données pour la voie de la carte vers le lecteur qui puisse assurer un débit de données augmenté tout en préservant la bande passante nécessaire pour la téléalimentation. L'invention est définie par les revendications. D'autres avantages et caractéristiques apparaîtront à la lecture de la description de l'invention, ainsi que des figures suivantes sur lesquelles :

- la figure 1 est un schéma montrant cinq motifs de codage en fonction du temps,
- la figure 2 est un schéma montrant un ensemble de 8 motifs,
- la figure 3 est un schéma montrant un ensemble de 16 motifs,
- la figure 4 est un schéma montrant un ensemble de 32 motifs selon l'invention,
- la figure 5 est un dispositif de rétromodulation pour la mise en oeuvre du procédé selon l'invention,
- la figure 6 montre sur un graphique l'évolution du paramètre 1/w qui est proportionnel à la bande passante en fonction du débit pour des approches évidentes et pour la solution selon l'invention.

Sur toutes les figures, les éléments identiques portent les mêmes numéros de référence.

Dans ce qui suit, le terme « symbole » signifie un élément d'un alphabet de codage de données. Un symbole peut par exemple être un ensemble de 3 bits, tel que 011.

Dans le présent contexte, on utilise le terme « motif ou motif de modulation » pour une succession de niveaux de charge d'une longueur prédéfinie servant au codage physique, c'est-à-dire la retromodulation.

Un motif de modulation correspond à un symbole et est caractérisé par sa longueur et une succession de niveaux de charge. Il sert au codage physique des données représentées sous forme de symboles.

La représentation temporelle d'un motif est le signal en bande de base, qui est transposé sur la porteuse d'une charge de retromodulation.

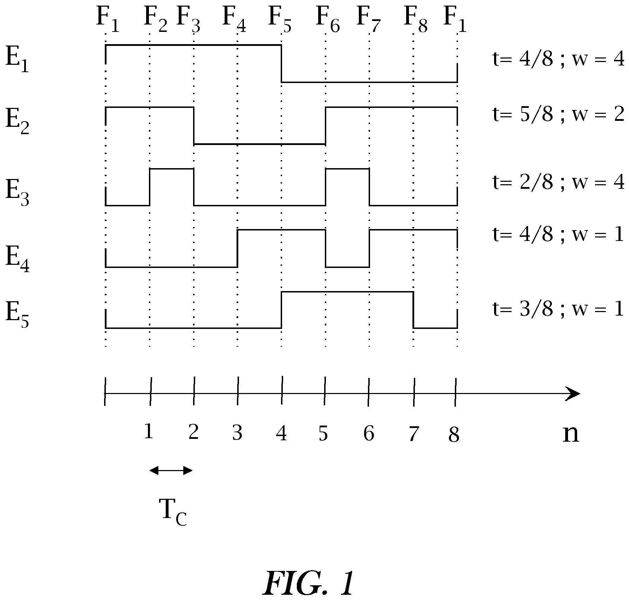

La figure 1 est un schéma montrant cinq motifs de codage $E_i$ (i=1 à 5) en fonction du temps.

L'échelle de temps est ici représentée en fonction du nombre de périodes de porteuse $T_C$, également appelé nombre de pas de porteuse.

$T_C = 1/f_C$, où $f_C$ est la fréquence de la porteuse qui est par exemple de 13,56 MHz, en conformité avec la norme ISO 14443.

La longueur des motifs $T_{SC}$ est égale à

$$T_{SC} = n * T_C = n/f_C \text{ où n est le nombre de pas de porteuse.}$$

où n est le nombre de pas de porteuse.

Dans tout l'exposé, n est un nombre entier naturel. Bien entendu, il est aisé à comprendre que n doit posséder une valeur supérieure ou égale à 1, par exemple 2, 4, 5, 6, 7 ou par exemple 8.

Dans le présent exemple, il a été choisi n=8, mais d'autres longueurs de motifs peuvent être envisagées.

Sur la figure 1, les motifs représentés $E_i$ (i=1 à 5), possèdent deux niveaux de charge, c'est-à-dire une valeur basse ou niveau bas lorsque la charge de rétromodulation n'est pas connectée à l'antenne et une valeur haute ou niveau haut lorsque la charge de rétromodulation est connectée à l'antenne.

Bien entendu, on peut aussi envisager des motifs formés avec plus de niveaux de charge, par exemple trois ou d'avantage, ce qui permet d'augmenter le nombre de bits codés par motif.

Il est rappelé que lorsque le transpondeur dissipe trop d'énergie dans sa charge de modulation (c'est-à-dire lorsque le motif est au niveau haut dans le présent exemple) il pénalise la récupération d'énergie..

Ainsi, on peut définir un taux de rétromodulation t comme suit :

$$t = r/n,$$

où r est le nombre (nombre entier) de pas de porteuse d'un motif pendant lequel la charge de rétromodulation est activée.

Ce paramètre est donc compris entre $0 \leq t \leq 1$ et plus t se rapproche de 1, plus l'énergie est dissipée dans la charge de rétromodulation $Z_R$, et moins le transpondeur dispose d'énergie pour fonctionner.

A titre d'exemple, les taux de rétromodulation t des motifs $E_i$ (i = 1 à 5) sont respectivement de 4/8, 5/8, 2/8, 4/8 et 3/8.

Un autre paramètre caractéristique des motifs est la largeur d'impulsion w qui est liée à la bande passante du motif. La largeur d'impulsion w est définie comme le nombre de pas de porteuse de la largeur d'impulsion (niveau de charge haut ou bas) minimale que peut contenir un motif.

A titre d'exemple, les largeurs d'impulsion w des motifs $E_i$ (i = 1 à 5) sont respectivement de 4 , 2, 1, 1, et 1.

La largeur d'impulsion w est liée à la bande passante du motif et permet de quantifier la bande passante pour la communication. La bande passante BP est au plus inversement proportionnelle à la largeur d'impulsion w. Par conséquent, plus la largeur d'impulsion w est élevée, plus la bande passante est resserrée et plus le transpondeur peut récupérer via l'antenne de l'énergie nécessaire à son fonctionnement.

Pour déterminer le débit, il est aussi nécessaire de connaître le nombre de bits p (p étant un nombre entier naturel) codés par motif.

Ainsi, si on souhaite coder des symboles de trois bits (000, 001, 010, ...., 111), il est nécessaire de disposer d'un ensemble de $2^3 = 8$ motifs.

Le débit binaire obtenu se calcule par la suite : $d = (p*f_C)/n$.

Le principe de l'invention consiste à s'affranchir des sous-porteuses simples ou déphasées et à définir des ensembles de motifs servant à coder des symboles binaires présentant une largeur d'impulsion moyenne w élevée (donc une bande passante resserrée) et un taux moyen de rétromodulation faible (donc permettant de diminuer la dissipation de l'énergie dans la charge de rétromodulation $Z_R$).

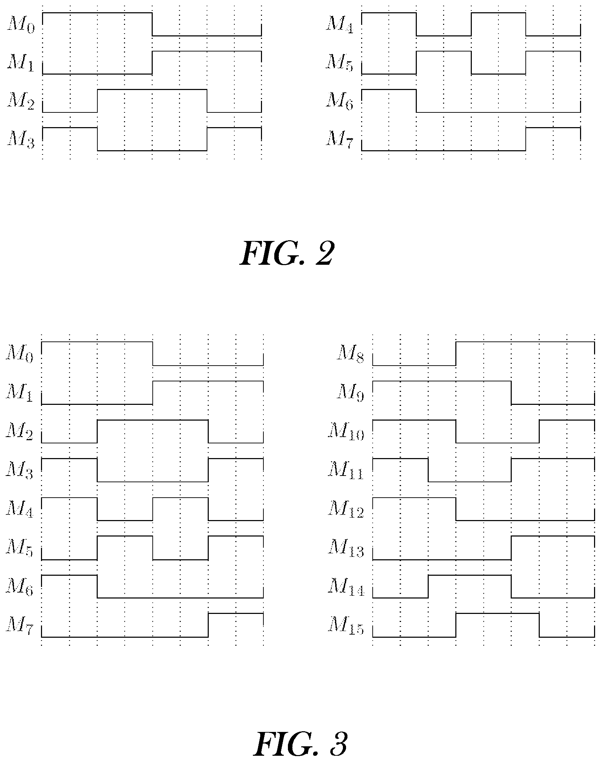

Les figures 2, 3, et 4 présentent respectivement des ensembles de 8, 16 et 32 motifs de modulation. Pour chacun des ensembles des motifs, la longueur n en termes de période de porteuse est de n=8.

L'invention s'applique seulement pour un ensemble contenant plus de quatre motifs (k>4, k étant un nombre entier).

Comme on peut le voir sur les figures 2 à 4, chaque motif comprend une succession d'au moins deux niveaux de charge. Bien entendu, on peut envisager d'avoir plus, par exemple trois niveaux de charge.

Par la suite, les motifs des figures 2, 3 et 4 peuvent être caractérisés de la manière suivante :

Table 1 : caractéristiques des motifs de la figure 2

|       | t   | w |   |       | t   | w |
|-------|-----|---|---|-------|-----|---|
| $M_0$ | 4/8 | 4 |   | $M_4$ | 4/8 | 2 |
| $M_1$ | 4/8 | 4 |   | $M_5$ | 4/8 | 2 |
|       | t   | w |   |       | t   | w |
| $M_2$ | 4/8 | 2 |   | $M_6$ | 2/8 | 2 |

(suite)

| | t | w | | | t | w |
|---|---|---|---|---|---|---|
| $M_3$ | 4/8 | 2 | | $M_7$ | 2/8 | 2 |

Pour l'ensemble des motifs de la figure 2, p= 3 et on a donc $2^3$ = 8 motifs. Bien entendu, il n'est pas nécessaire que le nombre de motifs soit un nombre qui est une puissance du chiffre 2, c'est-à-dire 2, 4, 8 etc.
On constate pour la table 1:

$$t_{moy} = 0,4375$$

$$w_{max} = 4 \; ; \; w_{min} = 2 \; .$$

Ainsi, pour cet ensemble de motifs de la figure 2, avec p = 3 (3 bits codés par motif), on peut atteindre un débit descendant de 5,1 Mbits/s avec une porteuse de 13,56MHz.

Table 2 : caractéristiques des motifs de la figure 3

| | t | w | | | t | w |
|---|---|---|---|---|---|---|
| $M_0$ | 4/8 | 4 | | $M_8$ | 5/8 | 3 |
| $M_1$ | 4/8 | 4 | | $M_9$ | 5/8 | 3 |
| $M_2$ | 4/8 | 2 | | $M_{10}$ | 5/8 | 2 |
| $M_3$ | 4/8 | 2 | | $M_{11}$ | 5/8 | 2 |
| $M_4$ | 4/8 | 2 | | $M_{12}$ | 3/8 | 3 |
| $M_5$ | 4/8 | 2 | | $M_{13}$ | 3/8 | 3 |
| $M_6$ | 2/8 | 2 | | $M_{14}$ | 3/8 | 2 |
| $M_7$ | 2/8 | 2 | | $M_{15}$ | 3/8 | 2 |

Pour l'ensemble des motifs de la figure 3, p= 4 et on a donc $2^4$ = 16 motifs.
On constate :

$$t_{moy} = 0,46875$$

$$w_{max} = 4 \; ; \; w_{min} = 2.$$

Ainsi, pour cet ensemble de motifs de la figure 3, avec p = 4 (4 bits codés par motif), on peut atteindre un débit descendant de 6,78 Mbits/s avec une porteuse de 13,56MHz.

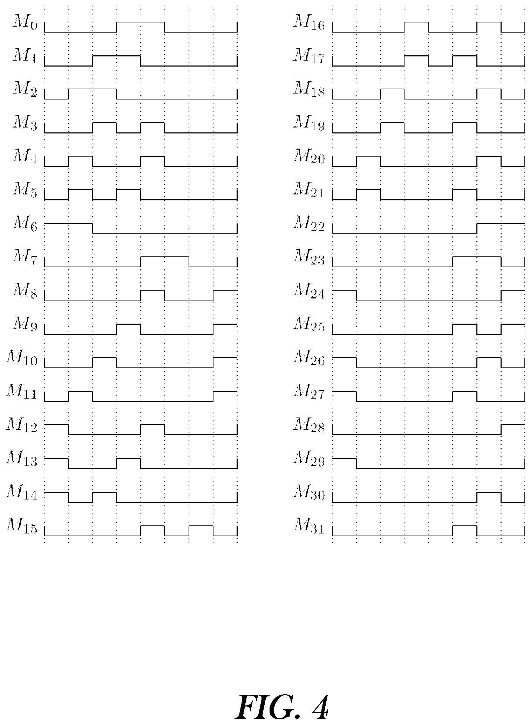

Table 3 : caractéristiques des motifs de la figure 4

| | t | w | | | t | w |
|---|---|---|---|---|---|---|
| $M_0$ | 2/8 | 2 | | $M_{16}$ | 2/8 | 1 |
| $M_1$ | 2/8 | 2 | | $M_{17}$ | 2/8 | 1 |
| $M_2$ | 2/8 | 2 | | $M_{18}$ | 2/8 | 1 |
| $M_3$ | 2/8 | 1 | | $M_{19}$ | 2/8 | 1 |
| $M_4$ | 2/8 | 1 | | $M_{20}$ | 2/8 | 1 |
| $M_5$ | 2/8 | 1 | | $M_{21}$ | 2/8 | 1 |

(suite)

|  | t | w |  |  | t | w |
|---|---|---|---|---|---|---|
| $M_6$ | 2/8 | 2 |  | $M_{22}$ | 2/8 | 2 |
| $M_7$ | 2/8 | 2 |  | $M_{23}$ | 2/8 | 2 |
| $M_8$ | 2/8 | 1 |  | $M_{24}$ | 2/8 | 1 |
| $M_9$ | 2/8 | 1 |  | $M_{25}$ | 2/8 | 1 |
| $M_{10}$ | 2/8 | 1 |  | $M_{26}$ | 2/8 | 1 |
| $M_{11}$ | 2/8 | 1 |  | $M_{27}$ | 2/8 | 1 |
| $M_{12}$ | 2/8 | 1 |  | $M_{28}$ | 1/8 | 1 |
| $M_{13}$ | 2/8 | 1 |  | $M_{29}$ | 1/8 | 1 |
| $M_{14}$ | 2/8 | 1 |  | $M_{30}$ | 1/8 | 1 |
| $M_{15}$ | 2/8 | 1 |  | $M_{31}$ | 1/8 | 1 |

Pour l'ensemble des motifs de la figure 4, p= 5 et on a donc $2^5$ = 32 motifs.

On constate :

$$t_{moy} = 0{,}2344$$

$$w_{max} = 2 \; ; \; w_{min} = 1.$$

Ainsi, pour cet ensemble de motifs de la figure 3, avec p = 5 (5 bits codés par motif), on peut atteindre un débit descendant de 8,5 Mbits/s avec une porteuse de 13,56MHz.

Comme on le voit sur les figures et dans les tables 1 à 3, pour chacun des ensembles présentés à titre d'exemple et non limitatif, les largeurs d'impulsion minimale, c'est-à-dire w, d'au moins deux motifs sont différentes, et les taux de rétromodulation t d'au moins deux motifs sont différents.

Si on souhaite resserrer la bande passante, il s'avère judicieux que la largeur d'impulsion minimale w ne soit pas inférieur à un.

Afin d'assurer une efficacité de téléalimentation, la largeur d'impulsion minimale, c'est-à-dire w, est proportionnelle à l'inverse de la bande passante de l'antenne du transpondeur.

Pour exploiter mieux le champ émis par un lecteur et améliorer la récupération d'énergie par le transpondeur, on choisit que le taux de rétromodulation moyen $t_{moy}$ soit inférieur à 0,5 pour l'ensemble des motifs choisis, comme cela est le cas dans les exemples des figures 2 à 4.

Dans les exemples présentés, parmi l'ensemble des motifs choisis, il y a au moins un des motifs qui présente une impulsion de largeur comprise entre 1 à (n-2*$w_{min}$) fois de périodes porteuse et qui possède un front F qui est en phase avec un des fronts de la porteuse. Cette impulsion du motif est située entre le front numéro $w_{min}$ et le front (n-w-$_{min}$), $w_{min}$ étant le minimum des largeurs d'impulsion minimale de l'ensemble des motifs, ce qui améliore la sécurité de transmission lors de l'enchaînement des motifs.

Sur la figure 1, on a présenté à titre indicatif les fronts $F_1$, $F_2$ à $F_8$. Il est à noter que par convention, le dernier front d'un motif appartient au motif suivant.

Pour la figure 1, $w_{min}$ = 1. On constate que le motif E4, possède une impulsion de largeur w=2 qui possède un front F4en phase avec le front de la porteuse (en pointillé) et qui est située entre le front $w_{min}$, c'est-à-dire le front $F_1$ et le front n-$w_{min}$, c'est-à-dire $F_7$.

L'ensemble des motifs choisis possède une entropie strictement inférieure à 1.

L'entropie est calculée selon la formule suivante :

$$H_b(X) = -\mathbf{E}[\log_b P(X = x_i)] = \sum_{i=1}^{n} P_i \log_b \left(\frac{1}{P_i}\right) = -\sum_{i=1}^{n} P_i \log_b P_i.$$

où

X est la source d'information en base b, qui délivre n niveaux de charge, chaque niveau de charge ayant une probabilité d'apparition de Pi.

Dans les présents exemples des figures 2 à 4, cela signifie :

- figure 2 : H = 0.98
- figure 3 : H = 0.997
- figure 4 : H = 0.798

Cette relation caractérise la dispersion / hétérogénéité des motifs contribuant à l'augmentation du débit.

Une autre caractéristique permettant de sécuriser la transmission des données concerne la distance de Hamming. En effet, on peut choisir la distance de Hamming entre deux motifs d'un ensemble de motifs supérieure à 2.

Puis, l'ensemble des motifs est construit de manière qu'au moins un motif de l'ensemble des motifs possède une succession de niveaux de charges dont les durées sont inférieures à $n/2 * T_C$, où $T_C$ est la période de la porteuse.

Pus spécifiquement, pour les exemples des figures où n=8, quatre motifs possèdent respectivement au moins une impulsion de largeur d'au moins deux périodes de porteuse (w=2).

De plus, dans l'ensemble des motifs, deux motifs possèdent respectivement deux impulsions séparées d'une largeur de deux périodes de porteuse.

En ce qui concerne l'exemple de la figure 3, l'ensemble des motifs est en outre caractéristique par le fait que quatre motifs ($M_{12}$, $M_{13}$, $M_{14}$, $M_{15}$) possèdent respectivement une impulsion de largeur d'au moins trois périodes de porteuse, décalées d'au moins une période porteuse les unes par rapport aux autres.

En ce qui concerne l'exemple de la figure 4, vingt motifs possèdent respectivement deux impulsions séparées d'une largeur d'au moins une période de porteuse ($M_3$, $M_4$, $M_5$, $M_8$, $M_9$, $M_{10}$, $M_{11}$, $M_{12}$, $M_{13}$, $M_{14}$, $M_{15}$, $M_{16}$, $M_{17}$, $M_{18}$, $M_{18}$, $M_{20}$, $M_{21}$, $M_{25}$, $M_{26}$, $M_{27}$).

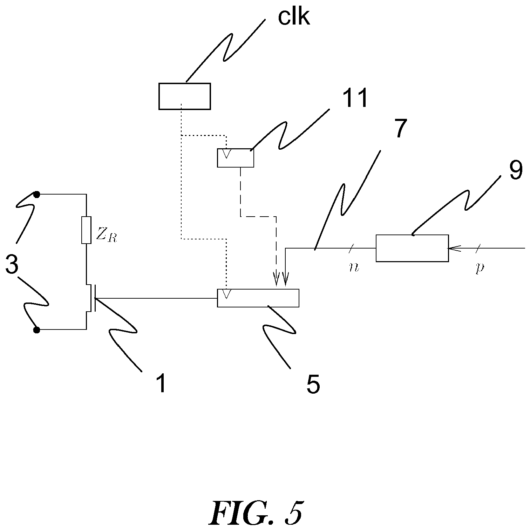

Le procédé de codage de données d'une communication sans contact d'un transpondeur vers un lecteur par modulation de charge, sous forme d'un ensemble de motifs peut être mis en oeuvre à l'aide d'un dispositif présenté par un schéma synoptique sur la figure 5.

La figure 5 présente donc un dispositif de rétromodulation, par exemple sous forme d'un circuit qui comprend un transistor de shunt 1 disposé en série avec l'impédance de charge $Z_R$ aux bornes 3 d'une antenne. La grille du transistor 1 est raccordée à un registre 5 de n bits à décalage à la fréquence de porteuse ($f_c$). Le registre 5 peut donc contenir un motif de longueur n.

L'entrée du registre 5 est reliée à une ligne de données en parallèle 7 des motifs à transmettre en provenance d'un circuit 9 de commande de modulation pour associer une liste de symboles à des motifs de modulation.

Le registre 5 est cadencé par une horloge clk à chaque période de porteuse. Cet horloge cadence également un compteur 11 de « 0 à n » qui provoque à chaque fois que le compteur 11 possède la valeur « 0 », une initialisation (« reset » en anglais) du registre.

Le fonctionnement du circuit est le suivant :

L'horloge clk cadence d'une part le registre 5 et d'autre part le compteur 11.

A chaque période d'horloge, la sortie du registre à décalage 5 présente la valeur courante du bit du motif qui commande directement la grille du transistor 1. Ainsi, si le bit est « 0 », la charge de rétromodulation $Z_R$ n'est pas connectée aux bornes de l'antenne 3, tandis que si le bit est « 1 », la charge de rétromodulation $Z_R$ est connectée aux bornes de l'antenne 3 et « écrase » le champ émis par le lecteur.

On comprend donc que la présente invention permet une augmentation considérable du débit entre un transpondeur et un lecteur tout en respectant la bande passante de l'antenne et le temps d'activation de la charge de rétromodulation pour assurer l'alimentation en énergie du transpondeur passif.

En complément aux dessins, les tables suivantes sont une transcription binaire (« 0 » - charge de rétromodulation déconnectée ; « 1 » - charge de rétromodulation connectée) des ensembles des motifs des figures 2 à 4.

Table 4 : transcription binaire des motifs de la figure 2

|        | $1*T_C$ | $2*T_C$ | $3*T_C$ | $4*T_C$ | $5*T_C$ | $6*T_C$ | $7*T_C$ | $8*T_C$ |
|--------|---------|---------|---------|---------|---------|---------|---------|---------|
| $M_0$  | 1       | 1       | 1       | 1       | 0       | 0       | 0       | 0       |
| $M_1$  | 0       | 0       | 0       | 0       | 1       | 1       | 1       | 1       |
| $M_2$  | 0       | 0       | 1       | 1       | 1       | 1       | 0       | 0       |

(suite)

|       | 1*T_C | 2*T_C | 3*T_C | 4*T_C | 5*T_C | 6*T_C | 7*T_C | 8*T_C |
|-------|-------|-------|-------|-------|-------|-------|-------|-------|
| $M_3$ | 1 | 1 | 0 | 0 | 0 | 0 | 1 | 1 |
| $M_4$ | 1 | 1 | 0 | 0 | 1 | 1 | 0 | 0 |
| $M_5$ | 0 | 0 | 1 | 1 | 0 | 0 | 1 | 1 |
| $M_6$ | 1 | 1 | 0 | 0 | 0 | 0 | 0 | 0 |
| $M_7$ | 0 | 0 | 0 | 0 | 0 | 0 | 1 | 1 |

Table 5 : transcription binaire des motifs de la figure 3

|       | 1*T_C | 2*T_C | 3*T_C | 4*T_C | 5*T_C | 6*T_C | 7*T_C | 8*T_C |
|-------|-------|-------|-------|-------|-------|-------|-------|-------|
| $M_0$ | 1 | 1 | 1 | 1 | 0 | 0 | 0 | 0 |
| $M_1$ | 0 | 0 | 0 | 0 | 1 | 1 | 1 | 1 |
| $M_2$ | 0 | 0 | 1 | 1 | 1 | 1 | 0 | 0 |
| $M_3$ | 1 | 1 | 0 | 0 | 0 | 0 | 1 | 1 |
| $M_4$ | 1 | 1 | 0 | 0 | 1 | 1 | 0 | 0 |
| $M_5$ | 0 | 0 | 1 | 1 | 0 | 0 | 1 | 1 |
| $M_6$ | 1 | 1 | 0 | 0 | 0 | 0 | 0 | 0 |
| $M_7$ | 0 | 0 | 0 | 0 | 0 | 0 | 1 | 1 |
| $M_8$ | 0 | 0 | 0 | 1 | 1 | 1 | 1 | 1 |
| $M_9$ | 1 | 1 | 1 | 1 | 1 | 0 | 0 | 0 |
| $M_{10}$ | 1 | 1 | 1 | 0 | 0 | 0 | 1 | 1 |
| $M_{11}$ | 1 | 1 | 0 | 0 | 0 | 1 | 1 | 1 |
| $M_{12}$ | 1 | 1 | 1 | 0 | 0 | 0 | 0 | 0 |
| $M_{13}$ | 0 | 0 | 0 | 0 | 0 | 1 | 1 | 1 |
| $M_{14}$ | 0 | 0 | 1 | 1 | 1 | 0 | 0 | 0 |
| $M_{15}$ | 0 | 0 | 0 | 1 | 1 | 1 | 0 | 0 |

Table 6 : transcription binaire des motifs de la figure 4

|       | 1*T_C | 2*T_C | 3*T_C | 4*T_C | 5*T_C | 6*T_C | 7*T_C | 8*T_C |
|-------|-------|-------|-------|-------|-------|-------|-------|-------|
| $M_0$ | 0 | 0 | 0 | 1 | 1 | 0 | 0 | 0 |
| $M_1$ | 0 | 0 | 1 | 1 | 0 | 0 | 0 | 0 |
| $M_2$ | 0 | 1 | 1 | 0 | 0 | 0 | 0 | 0 |
| $M_3$ | 0 | 0 | 1 | 0 | 1 | 0 | 0 | 0 |
| $M_4$ | 0 | 1 | 0 | 0 | 1 | 0 | 0 | 0 |
| $M_5$ | 0 | 1 | 0 | 1 | 0 | 0 | 0 | 0 |
| $M_6$ | 1 | 1 | 0 | 0 | 0 | 0 | 0 | 0 |
| $M_7$ | 0 | 0 | 0 | 0 | 1 | 1 | 0 | 0 |
| $M_8$ | 0 | 0 | 0 | 0 | 1 | 0 | 0 | 1 |
| $M_9$ | 0 | 0 | 0 | 1 | 0 | 0 | 0 | 1 |

(suite)

|        | 1*$T_C$ | 2*$T_C$ | 3*$T_C$ | 4*$T_C$ | 5*$T_C$ | 6*$T_C$ | 7*$T_C$ | 8*$T_C$ |
|--------|------|------|------|------|------|------|------|------|
| $M_{10}$ | 0 | 0 | 1 | 0 | 0 | 0 | 0 | 1 |
| $M_{11}$ | 0 | 1 | 0 | 0 | 0 | 0 | 0 | 1 |
| $M_{12}$ | 1 | 0 | 0 | 0 | 1 | 0 | 0 | 0 |
| $M_{13}$ | 1 | 0 | 0 | 1 | 0 | 0 | 0 | 0 |
| $M_{14}$ | 1 | 0 | 1 | 0 | 0 | 0 | 0 | 0 |
| $M_{15}$ | 0 | 0 | 0 | 0 | 1 | 0 | 1 | 0 |
| $M_{16}$ | 0 | 0 | 0 | 1 | 0 | 0 | 1 | 0 |
| $M_{17}$ | 0 | 0 | 0 | 1 | 0 | 1 | 0 | 0 |
| $M_{18}$ | 0 | 0 | 1 | 0 | 0 | 0 | 1 | 0 |
| $M_{19}$ | 0 | 0 | 1 | 0 | 0 | 1 | 0 | 0 |
| $M_{20}$ | 0 | 1 | 0 | 0 | 0 | 0 | 1 | 0 |
| $M_{21}$ | 0 | 1 | 0 | 0 | 0 | 1 | 0 | 0 |
| $M_{22}$ | 0 | 0 | 0 | 0 | 0 | 0 | 1 | 1 |
| $M_{23}$ | 0 | 0 | 0 | 0 | 0 | 1 | 1 | 0 |
| $M_{24}$ | 1 | 0 | 0 | 0 | 0 | 0 | 0 | 1 |
| $M_{25}$ | 0 | 0 | 0 | 0 | 0 | 1 | 0 | 1 |
| $M_{26}$ | 1 | 0 | 0 | 0 | 0 | 0 | 1 | 0 |
| $M_{27}$ | 1 | 0 | 0 | 0 | 0 | 1 | 0 | 0 |
| $M_{28}$ | 0 | 0 | 0 | 0 | 0 | 0 | 0 | 1 |
| $M_{29}$ | 1 | 0 | 0 | 0 | 0 | 0 | 0 | 0 |
| $M_{30}$ | 0 | 0 | 0 | 0 | 0 | 0 | 1 | 0 |
| $M_{31}$ | 0 | 0 | 0 | 0 | 0 | 1 | 0 | 0 |

Ci-après, on présente à titre d'exemple une table d'une transcrip - tion binaire (« 0 » - charge de rétromodulation déconnectée ; « 1 » - charge de rétromodulation connectée) pour n = 6.

Table 7 : transcription binaire de motifs pour n = 6

|       | 1*$T_C$ | 2*$T_C$ | 3*$T_C$ | 4*$T_C$ | 5*$T_C$ | 6*$T_C$ |
|-------|------|------|------|------|------|------|
| $M_0$ | 1 | 1 | 1 | 0 | 0 | 0 |
| $M_1$ | 0 | 0 | 1 | 1 | 0 | 0 |
| $M_2$ | 0 | 0 | 0 | 0 | 1 | 1 |
| $M_3$ | 0 | 0 | 0 | 1 | 1 | 1 |

On constate pour cet ensemble de 4 motifs:

$$t_{moy} = 0{,}4167 \text{ et } w_{min} = 2. \text{ L'entropie est dans ce cas } H = 0.979.$$

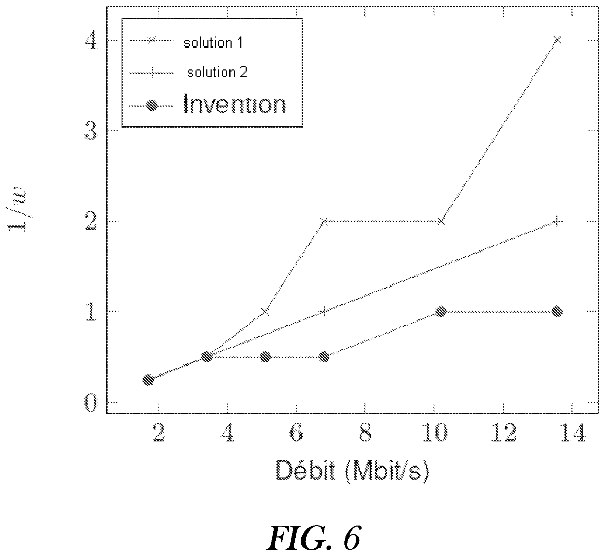

La figure 6 montre sur un graphique l'évolution du paramètre 1/w qui est proportionnel à la bande passante en fonction du débit pour des approches évidentes et pour la solution selon l'invention. Les solutions 1 et 2 correspondent respectivement aux solutions évidentes décrites en introduction consistant à augmenter le nombre de symboles ou à diminuer le temps symbole.

On constate que la solution selon l'invention se distingue largement et permet une augmentation significative du débit tout en gardant une bande passante restreinte assurant une pérennité pour la récupération d'énergie.

**Revendications**

1. Procédé de codage de données d'une communication sans contact d'un transpondeur passif vers un lecteur par modulation de charge, sous forme d'un ensemble de motifs de modulation, chaque motif

   - étant une succession de niveaux de charge d'une longueur prédéfinie servant au codage physique et

      - ayant une durée de n périodes de porteuse ($T_c$), n étant un nombre de pas de porteuse,
      - comprenant une succession d'au moins deux niveaux de charge,
      - ayant une largeur d'impulsion minimale (w) correspondant à la plus courte durée en nombre de pas de porteuse d'un même niveau de charge dans le motif, et
      - ayant un taux de rétromodulation (t) correspondant au rapport entre le temps de rétromodulation et la durée d'un motif, et dans lequel
      - chaque motif de l'ensemble des motifs code un nombre de bits p supérieur ou égal à 3,
      - le nombre (k) de motifs est supérieur à quatre, les largeurs d'impulsion minimale (w) d'au moins deux motifs sont différentes,
      - pour l'ensemble des motifs choisis, le taux de rétromodulation (t) moyen est inférieur à 0,5 et les taux de rétromodulation (t) d'au moins deux motifs sont différent,
      et **caractérisé en ce que**
      pour l'ensemble des motifs choisis, la largeur d'impulsion minimale ($w_{min}$) en nombre de pas de porteuse est inférieure ou égale à deux.

2. Procédé de codage de données selon l'une quelconque des revendications précédentes, **caractérisé en ce que** parmi l'ensemble des motifs choisis, il y a au moins un des motifs qui présente une impulsion d'une largeur comprise entre une période porteuse et (n-2*$w_{min}$) fois de périodes porteuse, et qui possède un front qui est en phase avec un des fronts de la porteuse et l'impulsion du motif est située entre le front positionné à l'index $w_{min}$ et le front (n-$w_{min}$), $w_{min}$ étant le minimum des largeurs d'impulsion minimale de l'ensemble des motifs.

3. Procédé de codage de données selon l'une quelconque des revendications précédentes, **caractérisé en ce que** l'entropie de l'ensemble des motifs est strictement inférieure à 1.

4. Procédé de codage de données selon l'une quelconque des revendications précédentes, **caractérisé en ce que** la distance de Hamming entre deux motifs d'un ensemble de motifs est supérieure à 2.

5. Procédé de codage de données selon l'une quelconque des revendications précédentes, **caractérisé en ce que** l'ensemble des motifs est formé à partir d'un nombre de niveaux de retromodulation supérieur ou égal à 3.

6. Procédé de codage de données selon l'une quelconque des revendications précédentes, **caractérisé en ce qu'**au moins un motif de l'ensemble des motifs possède une succession de niveaux de charges dont les durées sont inférieures à n/2 * $T_c$, où $T_c$ est la période de la porteuse.

7. Procédé de codage de données selon l'une quelconque des revendications précédentes, **caractérisé en ce que** la fréquence porteuse est de 13,56 MHz.

8. Procédé de codage de données selon la revendication 7, **caractérisé en ce que** n=8, et **en ce que** quatre motifs possèdent respectivement au moins une impulsion de largeur d'au moins deux périodes de porteuse.

9. Procédé de codage de données selon la revendication 7, caractérisé en que deux motifs possèdent respectivement deux impulsions séparées d'une largeur de deux périodes de porteuse.

10. Procédé de codage de données selon la revendication 7, caractérisé en que quatre motifs possèdent respectivement une impulsion de largeur d'au moins trois périodes de porteuse, décalées d'au moins une période porteuse les unes par rapport aux autres.

11. Procédé de codage de données selon la revendication 7, caractérisé en que vingt motifs possèdent respectivement deux impulsions séparées d'une largeur d'au moins une période de porteuse.

12. Dispositif de rétromodulation pour la mise en oeuvre d'un procédé selon l'une quelconque des revendications 1 à 11, **caractérisé en ce qu'**il comprend un transistor de shunt (1) et un registre (5) n bits à décalage à la fréquence de porteuse , le transistor de shunt (1) étant disposé en série avec l'impédance de charge ($Z_R$) aux bornes d'une antenne (3) et dont la grille est raccordée au registre (5) n bits à décalage à la fréquence de porteuse, dont l'entrée est reliée à une ligne (7) de données en parallèle des motifs à transmettre.

13. Carte RFID à transpondeur passif comprenant une antenne et un dispositif de rétromodulation selon la revendication 12 et un circuit (9) de commande de modulation pour associer une liste de symboles à des motifs de modulation.

**Patentansprüche**

1. Verfahren zur Codierung von Daten einer kontaktlosen Kommunikation von einem passiven Transponder zu einem Lesegerät durch Lastmodulation in Form eines Satzes von Modulationsmustern, wobei jedes Muster

- eine Abfolge von Lastniveaus mit vorgegebener Länge ist, die einer physischen Codierung dient, und
- eine Dauer von n Trägerperioden (Tc) hat, wobei n eine Anzahl von Trägerschritten ist,
- eine Abfolge von mindestens zwei Lastniveaus umfasst,
- eine minimale Pulsbreite (w) hat, die der kürzesten Dauer im Hinblick auf die Anzahl der Trägerschritte mit demselben Lastniveau in dem Muster entspricht, und
- eine Rückmodulationsrate (t) hat, die dem Verhältnis zwischen der Rückmodulationszeit und der Dauer eines Musters entspricht,

und wobei

- jedes Muster des Satzes der Muster eine Anzahl von Bits p größer als oder gleich 3 codiert,
- die Anzahl (k) der Muster größer als vier ist,
- die minimalen Pulsbreiten (w) von mindestens zwei Mustern verschieden sind,
- für den Satz der gewählten Muster die mittlere Rückmodulationsrate (t) kleiner als 0,5 ist und die Rückmodulationsraten (t) von mindestens zwei Mustern verschieden sind,

**dadurch gekennzeichnet, dass** für den Satz der gewählten Muster die minimale Pulsbreite ($w_{min}$) im Hinblick auf die Anzahl der Trägerschritte kleiner als oder gleich zwei ist.

2. Verfahren zur Codierung von Daten nach einem der vorhergehenden Ansprüche, **dadurch gekennzeichnet, dass** es unter dem Satz der gewählten Muster mindestens eines der Muster gibt, das einen Puls mit einer Breite zwischen einer Trägerperiode und dem ($n-2*w_{min}$)-Fachen der Trägerperiode aufweist und das eine Front besitzt, die in Phase mit einer der Fronten des Trägers ist, und der Puls des Musters liegt zwischen der am Index $w_{min}$ positionierten Front und der Front ($n-w_{min}$), wobei $w_{min}$ das Minimum der minimalen Pulsbreiten aller Muster ist.

3. Verfahren zur Codierung von Daten nach einem der vorhergehenden Ansprüche, **dadurch gekennzeichnet, dass** die Entropie des Satzes der Muster strikt kleiner als 1 ist.

4. Verfahren zur Codierung von Daten nach einem der vorhergehenden Ansprüche, **dadurch gekennzeichnet, dass** der Hamming-Abstand zwischen zwei Mustern eines Satzes von Mustern größer als 2 ist.

5. Verfahren zur Codierung von Daten nach einem der vorhergehenden Ansprüche, **dadurch gekennzeichnet, dass** der Satz der Muster anhand einer Anzahl von Rückmodulationsniveaus größer als oder gleich 3 gebildet wird.

6. Verfahren zur Codierung von Daten nach einem der vorhergehenden Ansprüche, **dadurch gekennzeichnet, dass** mindestens ein Muster des Satzes der Muster eine Abfolge von Lastniveaus besitzt, deren Dauern kleiner als $n/2 * T_c$ sind, wobei $T_c$ die Periode des Trägers ist.

7. Verfahren zur Codierung von Daten nach einem der vorhergehenden Ansprüche, **dadurch gekennzeichnet, dass** die Trägerfrequenz 13,56 MHz beträgt.

**8.** Verfahren zur Codierung von Daten nach Anspruch 7, **dadurch gekennzeichnet, dass** n=8 ist und dass vier Muster jeweils einen Puls mit einer Breite von mindestens zwei Trägerperioden besitzen.

**9.** Verfahren zur Codierung von Daten nach Anspruch 7, **dadurch gekennzeichnet, dass** zwei Muster jeweils zwei Pulse besitzen, die durch eine Breite von zwei Trägerperioden getrennt sind.

**10.** Verfahren zur Codierung von Daten nach Anspruch 7, **dadurch gekennzeichnet, dass** vier Muster jeweils einen Puls mit einer Breite von mindestens drei Trägerperioden besitzen, die um mindestens eine Trägerperiode zueinander versetzt sind.

**11.** Verfahren zur Codierung von Daten nach Anspruch 7, **dadurch gekennzeichnet, dass** zwanzig Muster jeweils zwei Pulse besitzen, die durch eine Breite von mindestens einer Trägerperiode getrennt sind.

**12.** Rückmodulationsvorrichtung zur Umsetzung eines Verfahrens nach einem der Ansprüche 1 bis 11, **dadurch gekennzeichnet, dass** sie einen Shunt-Transistor (1) und ein n-bit-Trägerfrequenzschieberegister (5) umfasst, wobei der Shunt-Transistor (1) in Reihe mit der Lastimpedanz ($Z_R$) an den Klemmen einer Antenne (3) angeordnet ist und sein Gatter an das n-bit-Trägerfrequenzschieberegister (5) angeschlossen ist, dessen Eingang mit einer parallelen Datenleitung (7) für zu übertragende Mustern verbunden ist.

**13.** RFID-Karte mit passivem Transponder, umfassend eine Antenne und eine Rückmodulationsvorrichtung nach Anspruch 12 und eine Schaltung (9) zur Steuerung der Modulation, um eine Liste mit Symbolen Modulationsmustern zuzuordnen.

**Claims**

**1.** Method for encoding contactless communication data from a passive transponder to a reader by load modulation, in the form of a set of modulation patterns, each pattern

- being a succession of load levels of a predefined length used for the physical encoding and
- having a duration of n carrier periods ($T_c$), n being a number of carrier steps,
- comprising a succession of at least two load levels,
- having a minimum pulse width (w) corresponding to the shortest duration in terms of number of carrier steps of a same load level in the pattern, and
- having a retromodulation rate (t) corresponding to the ratio between the retromodulation time and the duration of a pattern,
and in which
- each pattern of the set of patterns encodes a number of bits p greater than or equal to 3,
- the number (k) of patterns is greater than four,
- the minimum pulse widths (w) of at least two patterns are different,
- the retromodulation rates (t) of at least two patterns are different,
- for the set of chosen patterns, the average retromodulation rate (t) is less than 0.5 and
and **characterized in that**
- for the set of chosen patterns, the minimum pulse width ($w_{min}$) in terms of number of carrier steps is less than or equal to two.

**2.** Data encoding method according to any one of the preceding claims, **characterized in that**, from the set of chosen patterns, there is at least one of the patterns which has a pulse with a width between one carrier period and (n-2*$w_{min}$) times carrier periods, and which has an edge which is in phase with one of the edges of the carrier and the pulse of the pattern is situated between the edge positioned at the index $w_{min}$ and the edge (n-$w_{min}$), $w_{min}$ being the minimum of the minimum pulse widths of the set of patterns.

**3.** Data encoding method according to any one of the preceding claims, **characterized in that** the entropy of the set of patterns is strictly less than 1.

**4.** Data encoding method according to any one of the preceding claims, **characterized in that** the Hamming distance between two patterns of a set of patterns is greater than 2.

5. Data encoding method according to any one of the preceding claims, **characterized in that** the set of patterns is formed from a number of retromodulation levels greater than or equal to 3.

6. Data encoding method according to any one of the preceding claims, **characterized in that** at least one pattern of the set of patterns has a succession of load levels whose durations are less than $n/2 * T_c$, in which $T_c$ is the period of the carrier.

7. Data encoding method according to any one of the preceding claims, **characterized in that** the carrier frequency is 13.56 MHz.

8. Data encoding method according to Claim 7, **characterized in that** n=8, and **in that** four patterns respectively have at least one pulse with a width of at least two carrier periods.

9. Data encoding method according to Claim 7, **characterized in that** two patterns respectively have two pulses separated by a width of two carrier periods.

10. Data encoding method according to Claim 7, **characterized in that** four patterns respectively have a pulse with a width of at least three carrier periods, offset by at least one carrier period relative to one another.

11. Data encoding method according to Claim 7, **characterized in that** twenty patterns respectively have two pulses separated by a width of at least one carrier period.

12. Retromodulation device for implementing a method according to any one of Claims 1 to 11, **characterized in that** it comprises a shunt transistor (1) and an n-bit carrier frequency shift register (5), the shunt transistor (1) being arranged in series with the load impedance ($Z_R$) at the terminals of an antenna (3) and whose gate is connected to the n-bit carrier frequency shift register (5), whose input is linked to a data line (7) in parallel with the patterns to be transmitted.

13. Passive transponder RFID card comprising an antenna and a retromodulation device according to Claim 12 and a modulation control circuit (9) for associating a list of symbols with modulation patterns.

*FIG. 1*

**FIG. 2**

**FIG. 3**

FIG. 4

**FIG. 5**

FIG. 6

## RÉFÉRENCES CITÉES DANS LA DESCRIPTION

### Documents brevets cités dans la description

- WO 2007149219 A
- WO 03088499 A
- US 6422476 B